# EUROPEAN PATENT SPECIFICATION

(11) **EP 3 876 273 B1**
(45) Date of publication and mention of the grant of the patent: **03.04.2024**
(21) Application number: 19877829.2
(22) Date of filing: 17.10.2019
(51) Int. Cl.: H01L 23/29, H01L 23/31, C08L 63/00, C08K 3/013

(54) **ENCAPSULATING RESIN COMPOSITION FOR POWER DEVICE AND POWER DEVICE**
DICHTUNGSHARZZUSAMMENSETZUNG FÜR EINE LEISTUNGSVORRICHTUNG UND LEISTUNGSVORRICHTUNG
COMPOSITION DE RÉSINE DE SCELLEMENT DE DISPOSITIF D'ALIMENTATION ET DISPOSITIF D'ALIMENTATION

(30) Priority: 01.11.2018 JP 2018206796
(43) Date of publication of application: 08.09.2021
(73) Proprietor: Sumitomo Bakelite Co., Ltd., Shinagawa-ku Tokyo 140-0002 (JP)
(72) Inventor: KITADA Tetsuya, Tokyo 140-0002 (JP)
(74) Representative: Müller-Boré & Partner Patentanwälte PartG mbB
(86) International application number: PCT/JP2019/040848
(87) International publication number: WO 2020/090491

(56) References cited:
- WO-A1-2014/065152
- WO-A1-2015/146670
- JP-A- 2003 531 938
- JP-A- 2016 074 805
- JP-A- 2016 074 805
- JP-A- 2016 113 566
- JP-A- 2016 204 420

## Description

### TECHNICAL FIELD

The present invention relates to an encapsulating resin composition for a power device and a power device.

### BACKGROUND ART

Resin compositions containing epoxy resins have been actively developed as encapsulating resin compositions for encapsulating various electronic devices.

For example, it is described in Patent Document 1 that an epoxy resin composition for encapsulating a semiconductor includes an epoxy compound represented by a specific general formula, a phenol resin represented by a specific general formula, and an inorganic filler, for the purpose of maintaining the low viscosity during molding, or the like.

It is described in Patent Document 2 that an environment-responsive encapsulating epoxy resin composition having good thermal conductivity, flame retardancy, strength, and moldability, and excellent in mold releasability from a mold during molding and suppression of burrs contains a cresol novolac-type epoxy resin, a phenol novolac resin, triphenylphosphine, a mixture of a plurality of specific silica particles, a phosphazene compound, and a metal hydrate and/or a metal borate salt, as essential components. JP2016074805A discloses a resin composition for semiconductor sealing which contains a biphenyl aralkyl type epoxy resin, a phenol type curing agent, a curing catalyst, and an inorganic filler.

### RELATED DOCUMENT

### PATENT DOCUMENT

[Patent Document 1] Japanese Unexamined Patent Publication No. 2009-256475
[Patent Document 2] Japanese Unexamined Patent Publication No. 2012-067252

### SUMMARY OF THE INVENTION

### TECHNICAL PROBLEM

In recent years, demands for power devices, specifically high withstand voltage power devices, have been increased.

For example, in the transportation field, demands for high withstand voltage power devices are expanding due to the spread of electric vehicles (EVs) and railway development in emerging countries. In the consumer field, demands for high withstand voltage power devices also tend to increase with the spread of so-called eco-friendly home appliances and smart houses.

As a method of evaluating reliability of a high withstand voltage power device, an evaluation method called a high temperature reverse bias test is known. This test is also called a HTRB test, which is an acronym for English of High Temperature Reverse Bias.

Specifically, in the HTRB test, a voltage is applied to a power device containing an encapsulating material (a power element encapsulated with an encapsulating material, or the like) at a high temperature for a long time to evaluate the degree of increase in a leakage current and the degree of decrease in a breakdown voltage. Here, the "high temperature" is, for example, about 150°C to 175°C, the "long time" is, for example, about several hundred hours, and the applied voltage is, for example, about several hundred to several thousand volts.

When a voltage is applied to a power device to perform the HTRB test once, and then a voltage is applied to the power device again, the HTRB test is "failed" in a case where the leakage current increases or the breakdown voltage decreases. On the other hand, it can be said that a power device in which the leakage current does not increase or the breakdown voltage does not decrease even after performing the HTRB test has "excellent HTRB resistance".

Whether or not the HTRB resistance is excellent depends, of course, on a power element or the like encapsulated with an encapsulating material. On the other hand, according to the finding of the present inventor, even with the same power element, the HTRB resistance changes as changing the encapsulating resin composition used for encapsulating. That is, it is considered that the HTRB resistance of the power device can be enhanced by improving the encapsulating material (encapsulating resin composition).

However, as far as the present inventor knows, there is room for improvement in the performance of an encapsulating resin composition in the related art from the viewpoint of the HTRB resistance.

The present invention has been made in view of such circumstances. An object of the present invention is to provide an encapsulating resin composition capable of manufacturing a power device having excellent resistance to a high temperature reverse bias test (HTRB resistance).

### SOLUTION TO PROBLEM

The present inventor examined a design of an encapsulating resin composition for enhancing HTRB resistance, factors related to the HTRB resistance, and the like from various viewpoints. As a result of the examination, the present inventor has found that a half width of a current-time curve obtained in a case where a cured product of the encapsulating resin composition is measured by a thermally stimulated depolarization current method under specific conditions is closely related to the HTRB resistance.

Based on this finding, the present inventor further studied and completed the present invention provided below. Furthermore, the above problem was solved.

The present invention is as follows.

An encapsulating resin composition for a power device includes an epoxy resin (A), an inorganic filler (B), a curing agent (C), and a curing accelerator (D), wherein the inorganic filler (B) contains a surface-treated silica which is modified with a coupling agent, and in which the encapsulating resin composition is molded under a condition of 175°C for 2 minutes and then subjected to after-curing under a condition of 175°C for 4 hours to obtain a test piece having a diameter of 100 mm and a thickness of 2 mm, and a half width of a current-time curve obtained by measuring the test piece with a thermally stimulated depolarization current method according to an order of (i) to (v) below is equal to or less than 800 seconds,
(i) a temperature of the test piece is increased to 150°C at a rate of 5°C/min without applying a voltage,
(ii) a constant voltage of 500 V is applied for 30 minutes while maintaining the temperature of the test piece at 150°C,
(iii) the temperature of the test piece is lowered to 45°C at a rate of 5°C/min while applying the constant voltage of 500 V,
(iv) the application of the voltage is stopped while maintaining the temperature of the test piece at 45°C and the test piece is left to stand for 5 minutes, and
(v) the temperature of the test piece is increased at a rate of 3.5°C/min without applying a voltage to the test piece, and a value of a current flowing during the increase in the temperature is measured to obtain a current-time curve.

Furthermore, the present invention is as follows.

A power device includes a substrate, a power element mounted on the substrate, and an encapsulating material for encapsulating the power element,
in which the encapsulating material contains a cured product formed of the encapsulating resin composition described above.

### ADVANTAGEOUS EFFECTS OF INVENTION

According to the present invention, the encapsulating resin composition capable of producing the power device having excellent resistance to a high temperature reverse bias test (HTRB resistance) is provided.

### BRIEF DESCRIPTION OF THE DRAWINGS

The above described object and other objects, features and advantages will be further clarified with the preferred embodiments described below and the accompanying drawings.

FIG. 1 is a cross-sectional view showing an example of a power device.
FIG. 2 is a cross-sectional view showing an example of a power device (different from FIG. 1).

### DESCRIPTION OF EMBODIMENTS

Hereinafter, embodiments of the present invention will be described in detail with reference to the drawings.

In all drawings, components identical to those of the above embodiment are denoted by the same reference numerals, and description thereof will not be repeated as appropriate.

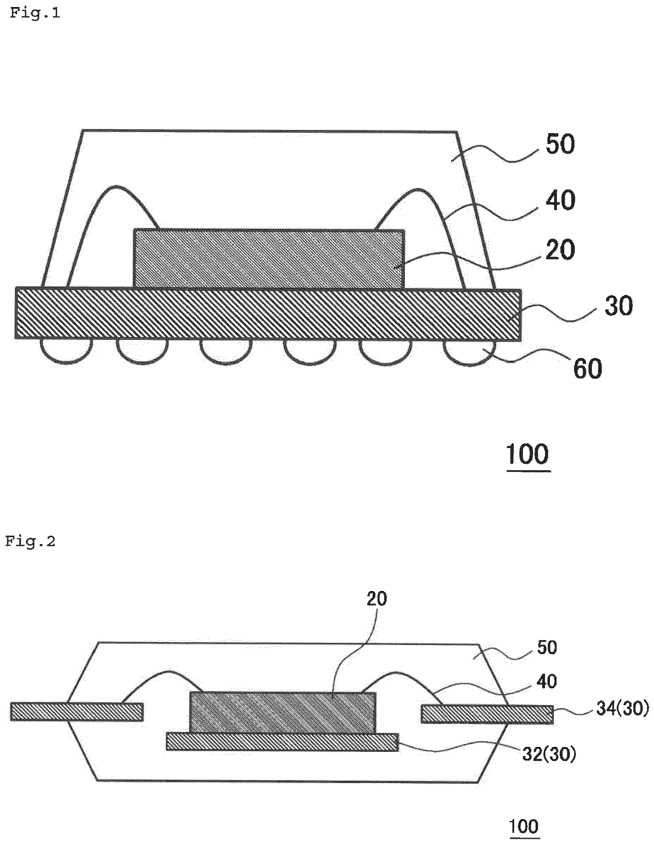

In order to avoid complexity, (i) in a case where there are a plurality of the same components in the same drawing, only one of the components is denoted by a reference numeral, and all the components are not denoted by a reference numeral, or (ii) particularly, in FIG. 2 and subsequent figures, the same components as those in FIG. 1 may not be denoted by reference numerals again.

All drawings are for illustration only. The shapes, dimensional ratios, and the like of each member in the drawings do not necessarily correspond to actual articles.

In the present specification, unless otherwise specified explicitly, the term "about" means to include a range in consideration of manufacturing tolerances, assembly variations, and the like.

Unless otherwise specified, the expression "a to b" in the description of the numerical range in the present specification means equal to or more than a and equal to or less than b. For example, "1 to 5% by mass" means "equal to or more than 1% by mass and equal to or less than 5% by mass".

In the expression of a group (atomic group) in the present specification, which is denoted without specifying whether substituted or unsubstituted, includes both a group having a substituent and a group having no substituent. For example, the term "alkyl group" includes not only an alkyl group having no substituent (unsubstituted alkyl group) but also an alkyl group having a substituent (substituted alkyl group).

The expression "(meth) acrylic" in the present specification represents a concept including both acrylic and methacrylic. The same applies to similar expressions such as "(meth)acrylate".

Unless otherwise specified, the term "organic group" in the present specification means an atomic group obtained by removing one or more hydrogen atoms from an organic compound. For example, the "monovalent organic group" represents an atomic group obtained by removing one hydrogen atom from any organic compound.

### <Encapsulating Resin Composition>

An encapsulating resin composition for a power device of the present embodiment includes an epoxy resin (A), an inorganic filler (B), wherein the inorganic filler (B) contains a surface-treated silica which is modified with a coupling agent, and a curing agent (C).

The encapsulating resin composition is molded under a condition of 175°C for 2 minutes and then subjected to after-curing under a condition of 175°C for 4 hours to obtain a test piece having a diameter of 100 mm and a thickness of 2 mm, and a half width of a current-time curve obtained by measuring the test piece with a thermally stimulated depolarization current method according to an order of (i) to (v) below is equal to or less than 800 seconds.
(i) A temperature of the test piece is increased to 150°C at a rate of 5°C/min without applying a voltage.
(ii) A constant voltage of 500 V is applied for 30 minutes while maintaining the temperature of the test piece at 150°C.
(iii) The temperature of the test piece is lowered to 45°C at a rate of 5°C/min while applying the constant voltage of 500 V.
(iv) The application of the voltage is stopped while maintaining the temperature of the test piece at 45°C and the test piece is left to stand for 5 minutes.
(v) The temperature of the test piece is increased at a rate of 3.5°C/min without applying a voltage to the test piece, and a value of a current flowing during the increase in the temperature is measured to obtain a current-time curve.

Before describing the encapsulating resin composition of the present embodiment, first, a thermally stimulated depolarization current method will be described.

The thermally stimulated depolarization current method is also called the TSDC method, which is an acronym for Thermally Stimulated Depolarization Current.

The measurement by the TSDC method is usually performed by the following procedure.
(1) A temperature of a sample is increased to a certain temperature T₁ and a constant voltage V is applied.
(2) After holding the sample in the state of (1) for an appropriate time, the temperature of the sample is decreased to a constant temperature T₂ while applying the voltage V. As a result, the polarization in the sample is frozen.
(3) The voltage is released while maintaining the temperature T₂, and the sample is left to stand during a predetermined time.
(4) The temperature of the sample is increased at a constant rate. The current flowing from the sample at this time (depolarization current) is recorded.

In brief, the TSDC method first generates polarization inside the sample by applying a voltage to the sample, and then measures a current (the relationship between the temperature and the depolarization current) obtained in a case where the temperature of the sample is increased without applying the voltage to alleviate the polarization.

The measurement by the TSDC method can be performed using, for example, a device of TS-POLAR manufactured by Rigaku Corporation.

Particularly, in a polymer sample, the alleviation of polarization (behavior of depolarization current) during the increase in the temperature reflects a molecular motion of a polymer in the sample. In other words, in the polymer sample, there is a correspondence relationship between alleviation of electrical polarization and a structural alleviation of the polymer itself.

In a case of studying the encapsulating resin composition capable of manufacturing a power device having an excellent HTRB resistance, the present inventor studied various factors that may be related to the HTRB resistance. During the study, cured products made of various encapsulating resin compositions were measured by the TSDC method, and whether behavior of depolarization current and the HTRB resistance were correlated was studied.

Through the studies, the present inventor found that in a case where the cured products of the encapsulating resin compositions are measured by the TSDC method, a peak width of a current-time curve (generally, a mountain-shaped curve with one peak) of the depolarization current, specifically, a "half width" may closely related to whether the HTRB resistance is good or bad. More specifically, the present inventor found that a power device encapsulated with a cured product of this encapsulating resin composition having a relatively small half width may exhibit a good HTRB resistance.

Based on these findings, the present inventor has designed a new encapsulating resin composition capable of producing a cured product in which a half width in a current-time curve of a depolarization current is equal to or less than a certain value. That is, in a case where the cured product is measured by the thermally stimulated depolarization current method under specific conditions (described above), a newly designed and prepared encapsulating resin composition having a half width of equal to or less than 800 seconds in the current-time curve is obtained. As a result, it is possible to obtain an encapsulating resin composition capable of manufacturing a power device having excellent HTRB resistance.

The reason why the power device having excellent HTRB resistance can be manufactured using the encapsulating resin composition in which the half width of the current-time curve in a case where the cured product is measured by the TSDC method is equal to or less than 800 seconds is not always clear. However, based on the findings, speculations, and the like of the present inventor, it can be explained as follows.

The following explanation includes guessing. The present invention should not be interpreted restrictively by the following description.

Again, in the polymer sample, the current-time curve measured by the TSDC method reflects the structural alleviation of the polymer polarized by applying a voltage after the voltage application is stopped.

Even described as a single word of the "structural alleviation of the polymer", there can be various modes such as (1) a structural alleviation due to local movement of relatively small atomic groups (for example, a polar group such as a hydroxy group), (2) a structural alleviation due to movement of polymer side chains, and (3) a structural alleviation due to movement of the entirety of polymer chains. As the sum of currents derived from the structural alleviations such as (1) to (3), the current-time curve is usually a mountain-shaped curve having one peak (maximum).

Here, the fact that the half width of the peak of the current-time curve is "large" (for example, more than 800 seconds) can be interpreted as corresponding to the fact that the above structural alleviations of (1) to (3) occur "evenly". That is, the temperatures at which the above structural alleviations such as (1) to (3) occur are different from each other, and it is considered that the total of depolarization currents due to these structural alleviations is represented as a current-time curve of a "broad peak".

On the other hand, the fact that the half width of the current-time curve is "small" (for example, equal to or less than 800 seconds) can be interpreted as corresponding to the fact that at least the structural alleviation of (3) among (1) to (3) is suppressed to a small extent, for example.

(There is a possibility that the structural alleviation of (1) or (2) is suppressed to a small extent, but since it is difficult in principle to suppress the movement of a small atomic group such as a hydroxy group, the structural alleviation of (3) may be highly suppressed to a small extent.)

The fact that the structural alleviation after the voltage application is stopped is suppressed (even in the mode (3) alone) means that the polarization and the structural change in a case where the voltage is applied are suppressed to a certain extent in the first place.

That is, a cured product having a small half width of the current-time curve (and an encapsulating resin composition for obtaining such a cured product) has a relatively small polarization during the voltage application. As a result, it is considered that in the power device encapsulated with such a cured product, an increase in a leakage current and a decrease in a breakdown voltage in the HTRB test can be suppressed.

From another viewpoint, it is considered that the structural alleviations of the above (1) and (2) occur at a relatively low temperature. That is, it can be said that in a cured product having a relatively large amount of the structural alleviations of (1) and (2) and a small amount of the structural alleviation of (3), electric charges are "less likely to remain" after a voltage is applied. It is considered that the HTRB resistance of the power device is improved by encapsulating the power device with the cured product (and an encapsulating resin composition for obtaining such a cured product) in which electric charges are less likely to remain.

The half width may be equal to or less than 800 seconds, but preferably equal to or less than 780 seconds, and more preferably equal to or less than 750 seconds. Basically, the narrower the half width, the better the HTRB resistance tends to be.

The lower limit value of the half width is not particularly limited, but is usually equal to or more than 500 seconds, more specifically equal to or more than 600 seconds.

The maximum value (peak height) of the current-time curve is not particularly limited, but is, for example, equal to or more than 750 pA, preferably equal to or more than 800 pA, and more preferably equal to or more than 820 pA. The upper limit of this peak height is, for example, equal to or less than 1500 pA, preferably equal to or less than 1350 pA, and more preferably equal to or less than 1250 pA.

In the present embodiment, the half width of the current-time curve in a case where the cured product is measured by the TSDC method under specific conditions can be equal to or less than 800 seconds by appropriately selecting, for example, kinds or the blending amount of raw materials used to prepare the encapsulating resin composition, a method of preparing an encapsulating resin composition, and the like.

In particular, the method of preparing an encapsulating resin composition (manufacturing method) is important. Even though the same or similar raw materials are used, in a case where the preparation method is inappropriate, the half width of the current-time curve of the cured product may not be equal to or less than 800 seconds.

Details of the method (manufacturing method) of preparing an encapsulating resin composition will be described later.

Components that are contained or may be contained in the encapsulating resin composition of the present embodiment will be described.

### (Epoxy Resin (A))

The encapsulating resin composition of the present embodiment contains the epoxy resin (A).

As the epoxy resin, an entirety of monomers, oligomers, or polymers having two or more epoxy groups in one molecule (that is, polyfunctional) can be used in general.

As the epoxy resin, a non-halogenated epoxy resin is particularly preferable.

Examples of the epoxy resin (A) can include biphenyl-type epoxy resins; bisphenol-type epoxy resins such as a bisphenol A-type epoxy resin, a bisphenol F-type epoxy resin, and a tetramethylbisphenol F-type epoxy resin; stilbene-type epoxy resins; novolac-type epoxy resins such as a phenol novolac-type epoxy resin and a cresol novolac-type epoxy resin; polyfunctional epoxy resins such as a triphenol methane-type epoxy resin and an alkyl modified triphenol methane-type epoxy resin; phenolaralkyl-type epoxy resins such as a phenolaralkyl-type epoxy resin with phenylene skeleton and a phenolaralkyl-type epoxy resin with biphenylene skeleton; naphthol-type epoxy resins such as a dihydroxynaphthalene-type epoxy resin and an epoxy resin obtained by glycidyl-etherification of a dimer of dihydroxynaphthalene; triazine nucleus-containing epoxy resins such as triglycidyl isocyanurate and monoallyl diglycidyl isocyanurate; bridged cyclic hydrocarbon compound-modified phenol-type epoxy resins such as a dicyclopentadiene-modified phenol-type epoxy resin, and the like.

The epoxy resin (A) preferably contains at least one of a bisphenol-type epoxy resin, a biphenyl-type epoxy resin, a novolac-type epoxy resin (for example, an o-cresol novolac epoxy resin), a phenolaralkyl-type epoxy resin, or a triphenol methane-type epoxy resin.

From the viewpoint of suppressing warpage of the power device, the epoxy resin (A) particularly preferably contains at least one of a phenolaralkyl-type epoxy resin or a novolac-type epoxy resin. In order to further improve fluidity, a biphenyl-type epoxy resin is particularly preferable, and in order to suppress the modulus of elasticity at a high temperature, a phenolaralkyl-type epoxy resin with biphenylene skeleton is particularly preferable.

Examples of the epoxy resin (A) include epoxy resins containing at least one selected from the group consisting of an epoxy resin represented by the following General Formula (1), an epoxy resin represented by the following General Formula (2), an epoxy resin represented by the following General Formula (3), an epoxy resin represented by the following General Formula (4), and an epoxy resin represented by the following General Formula (5). Among these, as one of preferable aspects, it is more preferable to contain at least one or more selected from the epoxy resin represented by the following General Formula (1) or the epoxy resin represented by the following General Formula (4)

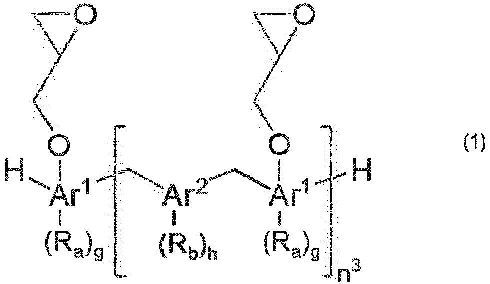

In General Formula (1),
Ar¹ represents a phenylene group or a naphthylene group, and in a case where Ar¹ is a naphthylene group, a glycidyl ether group may be bonded to either an α-position or a β-position.
Ar² represents any one of a phenylene group, a biphenylene group, or a naphthylene group.
Rₐ and R_{b} each independently represent a hydrocarbon group having 1 to 10 carbon atoms.
g is an integer of 0 to 5, and h is an integer of 0 to 8. n³ represents a degree of polymerization, and an average value thereof is 1 to 3.

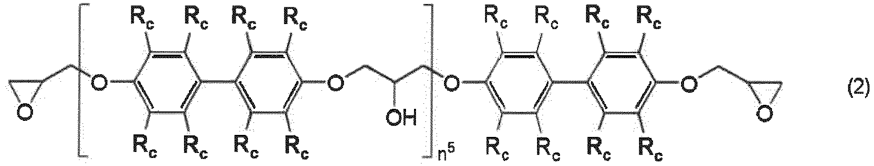

In General Formula (2),
a plurality of R_{c}'s each independently represent a hydrogen atom or a hydrocarbon group having 1 to 4 carbon atoms.
n⁵ represents a degree of polymerization, and an average value thereof is 0 to 4.

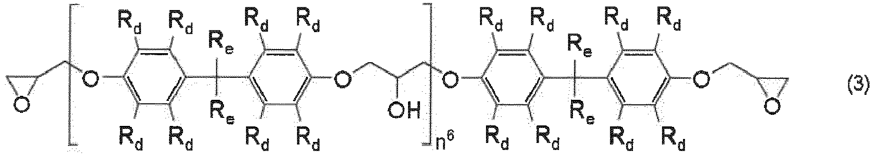

In General Formula (3),
a plurality of R_{d} and Rₑ each independently represent a hydrogen atom or a hydrocarbon group having 1 to 4 carbon atoms.
n⁶ represents a degree of polymerization, and an average value thereof is 0 to 4.

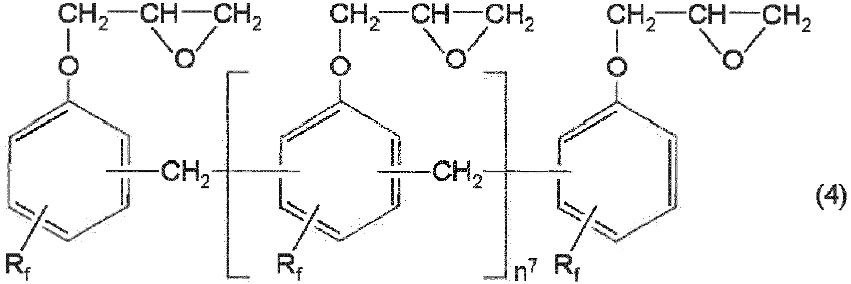

In General Formula (4),
a plurality of R_{f}'s each independently represent a hydrogen atom or a hydrocarbon group having 1 to 4 carbon atoms.
n⁷ represents a degree of polymerization, and an average value thereof is 0 to 4.

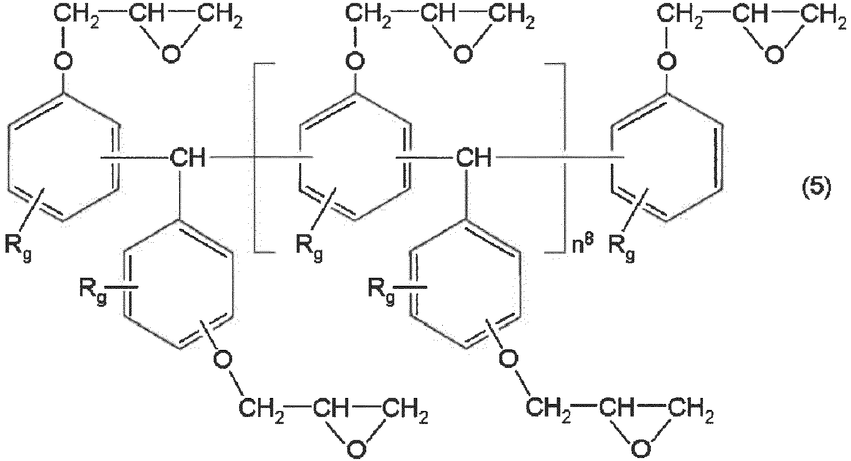

In General Formula (5),
a plurality of R_{g}'s each independently represent a hydrogen atom or a hydrocarbon group having 1 to 4 carbon atoms.
n⁸ represents a degree of polymerization, and an average value thereof is 0 to 4.

A number average molecular weight of the epoxy resin (A) is not particularly limited, and may be appropriately selected from the viewpoints of fluidity, curability, and the like. As an example, the number average molecular weight is about 100 to 700.

In addition, from the viewpoint of fluidity and the like, the ICI viscosity of the epoxy resin (A) at 150°C is preferably 0.1 to 5.0 poise.

The encapsulating resin composition may contain only one kind of the epoxy resin (A), or may contain two or more kinds thereof.

An epoxy equivalent of the epoxy resin (A) is preferably 100 to 400 g/eq, and more preferably 150 to 350 g/eq. In a case where the encapsulating resin composition contains a plurality of epoxy resins (A), it is preferable that the epoxy equivalent as the entirety of the plurality of epoxy resins (A) is within a range of the above numerical values.

The lower limit value of the amount of the epoxy resin (A) is preferably, for example, equal to or more than 3% by mass, more preferably equal to or more than 4% by mass, and particularly preferably equal to or more than 5% by mass with respect to the entirety of the encapsulating resin composition. Since a content of the epoxy resin (A) is within a range of equal to or more than the above lower limit value, the fluidity of the encapsulating resin composition can be improved and the moldability can be improved.

On the other hand, the upper limit value of the amount of the epoxy resin (A) is preferably, for example, equal to or less than 50% by mass, more preferably equal to or less than 30% by mass, and even more preferably equal to or less than 20% by mass with respect to the entirety of the encapsulating resin composition. Since the content of the epoxy resin (A) is within a range of equal to or less than the above upper limit value, moisture resistance reliability and reflow resistance of the power device provided with the encapsulating material formed by the encapsulating resin composition can be improved.

By appropriately selecting the epoxy equivalent of the epoxy resin (A) or appropriately adjusting the amount of the epoxy resin (A) in the encapsulating resin composition, a curing reaction in the composition is easily optimized. Therefore, it is considered that the HTRB resistance is easily increased.

In addition, it is considered that curing and flowing characteristics or the like of the composition can be appropriately adjusted by appropriately adjusting the epoxy equivalent or the amount of the epoxy resin. The curing and flowing characteristics can be evaluated by, for example, a spiral flow or a gel time.

### (Inorganic Filler (B))

The encapsulating resin composition of the present embodiment contains a surface-treated silica which is modified with a coupling agent. Examples of silica can include fused and crushed silica, fused spherical silica, crystalline silica, secondary aggregated silica, and the like. Among these, fused spherical silica is particularly preferable.

The inorganic filler (B) is usually particles. Shapes of the particles are preferably substantially spherical.

The average particle size of the inorganic filler (B) is not particularly limited, but is typically 1 to 100 um, preferably 1 to 50 µm, and more preferably 1 to 20 µm. By setting the average particle size appropriately, it is possible to secure an appropriate fluidity during the curing.

The average particle size of the inorganic filler (B) can be determined by acquiring volume-based particle size distribution data using a laser diffraction/scattering particle size distribution analyzer (for example, LA-950 of a wet-type particle size distribution measuring apparatus manufactured by HORIBA, Ltd.). Usually, the measurement is performed by a dry method.

The inorganic filler (B) comprises silica which is surface-modified with a coupling agent such as a silane coupling agent (before mixing all components to prepare an encapsulating resin composition) in advance.

As a result, aggregation of the inorganic filler (B) is suppressed, and better fluidity can be obtained. In addition, the affinity between the inorganic filler (B) and other components is enhanced, and the dispersibility of the inorganic filler (B) is improved. This is considered to contribute to the improvement of the mechanical strength of the cured product and the suppression of the occurrence of microcracks.

As the coupling agent used for surface treatment of the inorganic filler (B), examples of a coupling agent (E) described later can be used. Among these, primary aminosilanes such as γ-aminopropyltriethoxysilane and γ-aminopropyltrimethoxysilane can be preferably used.

The dispersibility of the inorganic filler (B) in the encapsulating resin composition can be improved by modifying the surface of the inorganic filler (B) with a group (an amino group or the like) capable of reacting with the epoxy resin (A).

In addition, the fluidity, the strength after curing, and the like of the encapsulating resin composition can be controlled by appropriately selecting a kind of the coupling agent used for the surface treatment of the inorganic filler (B) or appropriately adjusting the blending amount of the coupling agent.

The surface treatment of the inorganic filler (B) with the coupling agent can be performed, for example, as follows.

First, the inorganic filler (B) and the coupling agent are mixed and stirred using a mixer. As a known mixer, for example, a ribbon mixer or the like can be used for mixing and stirring. As a method of operating a mixer, (i) the inorganic filler (B) and the coupling agent may be charged in the mixer in advance and then blades may be rotated, or (ii) first, only the inorganic filler (B) may be charged while rotating the blades and then the coupling agent may be added little by little into the mixer with a spray nozzle or the like.

During the mixing and stirring, it is preferable to maintain low humidity inside the mixer low (for example, humidity of 50% or less). By setting the humidity to low, it is possible to suppress the adhesion of water to the surface of the inorganic filler (B). Furthermore, it is possible to suppress the coupling agents from being mixed with water and reacting with each other.

Subsequently, the obtained mixture is taken out from the mixer and subjected to aging treatment to accelerate a coupling reaction. The aging treatment is carried out by, for example, leaving the mixture to stand for one day or more (preferably one to seven days) under conditions of 20±5°C and 40% to 50% RH. By carrying out the aging treatment under such conditions, the coupling agent can be uniformly bonded to the surface of the inorganic filler (B).

After the aging treatment, coarse particles are removed by sieving to obtain the surface-treated (coupling treatment) inorganic filler (B).

The encapsulating resin composition may contain only one kind of the inorganic filling material (B), or may contain two or more kinds thereof.

The lower limit value of a content of the inorganic filling material (B) is preferably, for example, equal to or more than 35% by mass, more preferably equal to or more than 50% by mass, and even more preferably equal to or more than 65% by mass with respect to the entirety of the encapsulating resin composition.

The upper limit value of the content of the inorganic filling material (B) is preferably, for example, equal to or less than 95% by mass, more preferably equal to or less than 93% by mass, and even more preferably equal to or less than 90% by mass.

It is considered that the curing and flowing characteristics or the like of the composition can be appropriately adjusted while obtaining a sufficient HTRB resistance by appropriately adjusting the amount of the inorganic filler (B).

### (Curing Agent (C))

The encapsulating resin composition of the present embodiment contains the curing agent (C).

The curing agent (C) is not particularly limited as long as the curing agent can react with the epoxy resin (A). Examples thereof include a phenol-based curing agent, an amine-based curing agent, an acid anhydride-based curing agent, a mercaptan-based curing agent, and the like.

Among these, a phenol-based curing agent is preferable from the viewpoint of a balance between flame resistance, moisture resistance, electrical characteristics, curability, storage stability, and the like.

### · Phenol-Based Curing Agent

A phenol-based curing agent is not particularly limited as long as the agent is generally used in the encapsulating resin composition. Examples thereof include novolac resins obtained by the condensation or co-condensation of phenols such as phenol, cresol, resorcin, catechol, bisphenol A, bisphenol F, phenylphenol, aminophenol, α-naphthol, β-naphthol, and dihydroxynaphthalene with formaldehydes or ketones in the presence of an acidic catalyst, the novolac resins encompassing a phenol novolac resin and a cresol novolac resin; phenolaralkyl resins such as a phenolaralkyl resin having a phenylene skeleton, synthesized from the phenols and dimethoxyparaxylene or bis (methoxymethyl) biphenyl, and a phenolaralkyl resin having a biphenylene skeleton; and phenol resins having a trisphenylmethane skeleton. These may be used alone or in combination of two or more kinds thereof.

### · Amine-Based Curing Agent

Examples of the amine-based curing agent include polyamine compounds including dicyandiamide (DICY), an organic acid dihydrazide, or the like, in addition to aliphatic polyamines such as diethylenetriamine (DETA), triethylenetetramine (TETA), and metaxylylene diamine (MXDA), and aromatic polyamines such as diaminodiphenylmethane (DDM), m-phenylenediamine (MPDA), and diaminodiphenylsulfone (DDS). These may be used alone or in combination of two or more kinds thereof.

### · Acid Anhydride-Based Curing Agent

Examples of the acid anhydride-based curing agent include alicyclic acid anhydrides such as hexahydrophthalic anhydride (HHPA), methyltetrahydrophthalic anhydride (MTHPA), and maleic anhydride, and aromatic acid anhydrides such as trimellitic anhydride (TMA), pyromellitic anhydride (PMDA), benzophenonetetracarboxylic dianhydride (BTDA), and phthalic anhydride. These may be used alone or in combination of two or more kinds thereof.

### · Mercaptan-Based Curing Agent

Examples of the mercaptan-based curing agent include trimethylolpropane tris(3-mercaptobutyrate) and trimethylol ethane tris(3-mercaptobutyrate). These may be used alone or in combination of two or more kinds thereof.

### · Other Curing Agents

Examples of other curing agents include isocyanate compounds such as an isocyanate prepolymer and a blocked isocyanate, and organic acids such as a carboxylic acid-containing polyester resin. These may be used alone or in combination of two or more kinds thereof.

As the curing agent (C), two or more different kinds may be used in combination. For example, the present embodiment also includes the use of a phenol-based curing agent and an amine-based curing agent in combination.

The encapsulating resin composition may contain only one kind of the curing agent (C), or may contain two or more kinds thereof.

The amount of the curing agent (C) is preferably, for example, equal to or more than 0.5% by mass, more preferably equal to or more than 1% by mass, and particularly preferably equal to or more than 1.5% by mass with respect to the entirety of the encapsulating resin composition.

On the other hand, a content of the curing agent (C) is preferably equal to or less than 9% by mass, more preferably equal to or less than 8% by mass, and particularly preferably equal to or less than 7% by mass with respect to the entirety of the encapsulating resin composition.

It is considered that the curing and flowing characteristics or the like of the composition can be appropriately adjusted while obtaining a sufficient HTRB resistance by appropriately adjusting the amount of the curing agent (C).

As another viewpoint, it is preferable that the amount of the curing agent (C) is appropriately adjusted in relation to the amount of the epoxy resin (A). Specifically, it is preferable that the so-called "molar equivalent" (molar ratio of reactive groups) is appropriately adjusted.

For example, in a case where the curing agent (C) is a phenol-based curing agent, the amount of the epoxy resin (A) with respect to the phenol-based curing agent is preferably 0.9 to 1.5, more preferably 1.0 to 1.4, even more preferably 1.0 to 1.3, and particularly preferably 1.01 to 1.20 in terms of the molar equivalent of the functional group (epoxy group/hydroxy group).

### (Curing Accelerator (D))

The encapsulating resin composition of the present embodiment contains the curing accelerator (D). The curing accelerator (D) may be any one that promotes the reaction (typically, a cross-linking reaction) between the epoxy resin (A) and the curing agent (C).

Examples of the curing accelerator (D) include one or two or more selected from phosphorus atom-containing compounds such as an organic phosphine, a tetra-substituted phosphonium compound, a phosphobetaine compound, an adduct of a phosphine compound and a quinone compound, and an adduct of a phosphonium compound and a silane compound; and nitrogen atom-containing compounds such as amidines or tertiary amines such as 1,8-diazabicyclo[5.4.0]undecene-7, benzyldimethylamine, and 2-methylimidazole, and quaternary salts of the amidines or the amines.

Among these, the phosphorus atom-containing compounds are preferably included from the viewpoint of improving the curability. In addition, from the viewpoint of improving a balance between moldability and curability, it is more preferable to include those having a potential, such as a tetra-substituted phosphonium compound, a phosphobetaine compound, an adduct of a phosphine compound and a quinone compound, and an adduct of a phosphonium compound and a silane compound.

Examples of the organic phosphine include primary phosphines such as ethylphosphine and phenylphosphine; secondary phosphines such as dimethylphosphine and diphenylphosphine; and tertiary phosphines such as trimethylphosphine, triethylphosphine, tributylphosphine, and triphenylphosphine.

Examples of the tetra-substituted phosphonium compound include a compound represented by the following General Formula (6) .

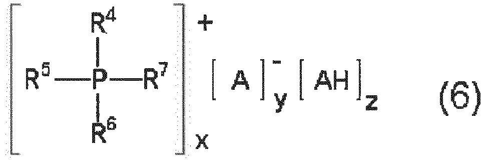

In General Formula (6),
P represents a phosphorus atom.
R⁴, R⁵, R⁶, and R⁷ each independently represent an aromatic group or an alkyl group.
A represents an anion of an aromatic organic acid having at least one functional group selected from a hydroxyl group, a carboxyl group, and a thiol group in an aromatic ring.
AH represents an aromatic organic acid having at least one functional group selected from a hydroxyl group, a carboxyl group, and a thiol group in an aromatic ring.
x and y are each a number of 1 to 3, and z is a number of 0 to 3, with x = y.

The compound represented by General Formula (6) can be obtained, for example, as follows.

First, a tetra-substituted phosphonium halide, an aromatic organic acid, and a base are added to an organic solvent and uniformly mixed to produce an aromatic organic acid anion in the solution system. Subsequently, water is added to the solution, and thus, the compound represented by General Formula (6) can be precipitated. In the compound represented by General Formula (6), R⁴, R⁵, R⁶, and R⁷, all of which are bonded to a phosphorus atom, are each preferably a phenyl group, AH is preferably a compound in which a hydroxyl group is bonded to an aromatic ring, that is, phenols, and A is preferably an anion of the phenols. Examples of the phenols include monocyclic phenols such as phenol, cresol, resorcin, and catechol, fused polycyclic phenols such as naphthol, dihydroxynaphthalene, and anthraquinol, bisphenols such as bisphenol A, bisphenol F, and bisphenol S, and polycyclic phenols such as phenylphenol and biphenol.

Examples of the phosphobetaine compound include a compound represented by General Formula (7).

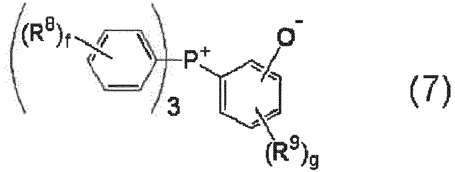

In General Formula (7),
P represents a phosphorus atom.
R⁸ represents an alkyl group having 1 to 3 carbon atoms, and R⁹ represents a hydroxyl group.
f is a number of 0 to 5, and g is a number of 0 to 3.

The compound represented by General Formula (7) can be obtained, for example, as follows.

First, a step of bringing a triaromatic-substituted phosphine which is a tertiary phosphine into contact with a diazonium salt to substitute the triaromatic-substituted phosphine with a diazonium group contained in the diazonium salt is carried out to obtain the compound represented by General Formula (7).

Examples of the adduct of a phosphine compound and a quinone compound include a compound represented by General Formula (8).

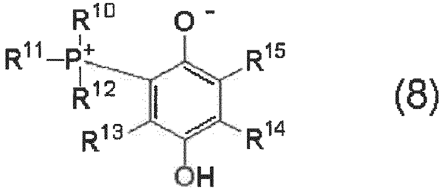

In General Formula (8),
P represents a phosphorus atom.
R¹⁰, R¹¹, and R¹² each represent an alkyl group having 1 to 12 carbon atoms or an aryl group having 6 to 12 carbon atoms, and may be the same as or different from each other.
R¹³, R¹⁴, and R¹⁵ each represent a hydrogen atom or a hydrocarbon group having 1 to 12 carbon atoms, may be the same as or different from each other, or R¹⁴ and R¹⁵ may be bonded to form a cyclic structure.

As the phosphine compound used for the adduct of a phosphine compound and a quinone compound, for example, phosphines containing an aromatic ring, such as triphenylphosphine, tris(alkylphenyl)phosphine, tris(alkoxyphenyl)phosphine, trinaphthylphosphine, and tris(benzyl)phosphine, in which the aromatic ring may be unsubstituted or have a substituent such as an alkyl group and an alkoxy group are preferable. Examples of the substituent such as an alkyl group and an alkoxy group include an alkyl group and an alkoxy group, each having 1 to 6 carbon atoms. From the viewpoint of easy availability, triphenylphosphine is preferable.

Examples of the quinone compound used for the adduct of a phosphine compound and a quinone compound include benzoquinone and anthraquinones. Among these, from the viewpoint of storage stability, p-benzoquinone is preferable.

As a method of producing an adduct of a phosphine compound and a quinone compound, an organic tertiary phosphine can be brought into contact with a benzoquinone in a solvent that can dissolve both the organic tertiary phosphine and the benzoquinone and mixed to produce an adduct thereof. As the solvent, ketones such as acetone and methyl ethyl ketone may be used, with the solvent having a low solubility of the adduct therein being preferable. However, the solvent is not limited thereto.

The compound represented by General Formula (8), in which R¹⁰, R¹¹, and R¹², all bonded to a phosphorus atom, are each preferably a phenyl group, and R¹³, R¹⁴, and R¹⁵ are each preferably a hydrogen atom, that is, the compound produced by adding 1,4-benzoquinone to triphenylphosphine is preferable since the compound decreases the modulus of elasticity during heating of a cured product of the encapsulating resin composition.

Examples of the adduct of a phosphonium compound and a silane compound include a compound represented by General Formula (9).

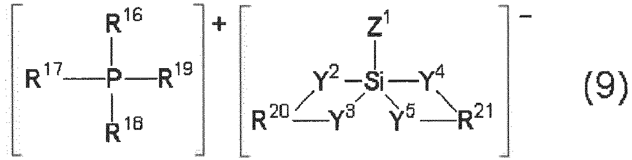

In General Formula (9),
P represents a phosphorus atom and Si represents a silicon atom.
R¹⁶, R¹⁷, R¹⁸, and R¹⁹ each represent an organic group having an aromatic ring or a heterocyclic ring, or an aliphatic group, and may be the same as or different from each other.

In the formula, R²⁰ is an organic group which is bonded to groups Y² and Y³.

In the formula, R²¹ is an organic group which is bonded to groups Y⁴ and Y⁵.

Y² and Y³ each represent a group formed in a case where a proton-donating group releases a proton, and the groups Y² and Y³ in the same molecule are bonded to the silicon atom to form a chelate structure.

Y⁴ and Y⁵ each represent a group formed in a case where a proton-donating group releases a proton, and the groups Y⁴ and Y⁵ in the same molecule are bonded to the silicon atom to form a chelate structure.

R²⁰ and R²¹ may be the same as or different from each other, and the groups Y², Y³, Y⁴, and Y⁵ may be the same as or different from each other.

Z¹ is an organic group having an aromatic ring or a heterocyclic ring, or an aliphatic group.

In General Formula (9), examples of R¹⁶, R¹⁷, R¹⁸, and R¹⁹ include a phenyl group, a methylphenyl group, a methoxyphenyl group, a hydroxyphenyl group, a naphthyl group, a hydroxynaphthyl group, a benzyl group, a methyl group, an ethyl group, a n-butyl group, a n-octyl group, and a cyclohexyl group, and among these, aromatic groups having a substituent such as an alkyl group, an alkoxy group, and a hydroxyl group, and unsubstituted aromatic groups, such as a phenyl group, a methylphenyl group, a methoxyphenyl group, a hydroxyphenyl group, and a hydroxynaphthyl group, are more preferable.

In General Formula (9), R²⁰ is an organic group which is bonded to Y² and Y³. Similarly, R²¹ is an organic group which is bonded to the groups Y⁴ and Y⁵. Y² and Y³ are each a group formed in a case where a proton-donating group releases a proton, and the groups Y² and Y³ in the same molecule are bonded to the silicon atom to form a chelate structure. Similarly, Y⁴ and Y⁵ are each a group formed in a case where a proton-donating group releases a proton, and the groups Y⁴ and Y⁵ in the same molecule are bonded to the silicon atom to form a chelate structure. The groups R²⁰ and R²¹ may be the same as or different from each other, and the groups Y², Y³, Y⁴, and Y⁵ may be the same as or different from each other. The groups represented by -Y²-R²⁰-Y³- and Y⁴-R²¹-Y⁵- in General Formula (9) are each a group formed in a case where a proton donor releases two protons. As the proton donor, an organic acid having at least two carboxyl groups or hydroxyl groups in the molecule is preferable, an aromatic compound having at least two carboxyl groups or hydroxyl groups in the adjacent carbons constituting the aromatic ring is even more preferable, and an aromatic compound having at least two hydroxyl groups in the adjacent carbons constituting the aromatic ring is more preferable. Examples thereof include catechol, pyrogallol, 1,2-dihydroxynaphthalene, 2,3-dihydroxynaphthalene, 2,2'-biphenol, 1,1'-bi-2-naphthol, salicylic acid, 1-hydroxy-2-naphthoic acid, 3-hydroxy-2-naphthoic acid, chloranilic acid, tannic acid, 2-hydroxybenzyl alcohol, 1,2-cyclohexanediol, 1,2-propanediol, and glycerin, but among these, catechol, 1,2-dihydroxynaphthalene, and 2,3-dihydroxynaphthalene are more preferable.

Z¹ in General Formula (9) is an organic group having an aromatic ring or a heterocyclic ring, or an aliphatic group. Specific examples thereof include aliphatic hydrocarbon groups such as a methyl group, an ethyl group, a propyl group, a butyl group, a hexyl group, and an octyl group, aromatic hydrocarbon groups such as a phenyl group, a benzyl group, a naphthyl group, and a biphenyl group, and reactive substituents such as an alkyl group having a glicydyloxy group, a mercapto group, or an amino group, such as a glycidyloxypropyl group, a mercaptopropyl group, and an aminopropyl group, and a vinyl group. However, among these, a methyl group, an ethyl group, a phenyl group, a naphthyl group, and a biphenyl group are more preferable in view of thermal stability.

A method of producing an adduct of a phosphonium compound and a silane compound is as follows.

A silane compound such as phenyltrimethoxysilane and a proton donor such as 2,3-dihydroxynaphthalene are added to methanol in a flask, and dissolved, and a sodium methoxide-methanol solution is added dropwise thereto under stirring at room temperature. Furthermore, a solution prepared by dissolving a tetra-substituted phosphonium halide such as tetraphenyl phosphonium bromide in methanol in advance is added dropwise to the resulting reaction product under stirring at room temperature to precipitate crystals. The precipitated crystals are filtered, washed with water, and dried in vacuum to obtain an adduct of the phosphonium compound and the silane compound.

The encapsulating resin composition may contain only one kind of the curing accelerator (D), or may contain two or more kinds thereof.

A content of the curing accelerator (D) is preferably equal to or more than 0.01% by mass, more preferably equal to or more than 0.05% by mass, and even more preferably equal to or more than 0.10% by mass with respect to the entirety of the encapsulating resin composition.

On the other hand, the content of the curing accelerator (D) is preferably equal to or less than 2.0% by mass, more preferably equal to or less than 1.5% by mass, and even more preferably equal to or less than 1.0% by mass with respect to the entirety of the encapsulating resin composition.

It is considered that the curing and flowing characteristics or the like of the composition can be appropriately adjusted while obtaining a sufficient HTRB resistance by appropriately adjusting the amount of the curing accelerator (D).

### (Coupling Agent (E))

The encapsulating resin composition of the present embodiment preferably contains the coupling agent (E). The coupling agent (E) herein is contained in the encapsulating resin composition as a simple substance of the coupling agent (E). For example, the coupling agent (combined with the inorganic filler (B)) used for the surface treatment of the inorganic filler (B) described above does not correspond to the coupling agent (E) herein.

As the coupling agent (E), known coupling agents such as various silane-based compounds such as epoxysilane, mercaptosilane, aminosilane, alkylsilane, ureidosilane, vinylsilane, and methacrylsilane, titanium-based compounds, aluminum chelates, and aluminum/zirconium-based compounds can be used.

More specifically, the following can be exemplified.

### · Silane-Based Coupling Agent

Vinyltrichlorosilane, vinyltrimethoxysilane, vinyltriethoxysilane, vinyltris (β-methoxyethoxy)silane, γ-methacryloxypropyltrimethoxysilane, β-(3,4-epoxycyclohexyl)ethyltrimethoxysilane, γ-glycidoxypropyltrimethoxysilane, γ-glycidoxypropyltriethoxysilane, γ-glycidoxypropyl Methyldimethoxysilane, γ-methacryloxypropylmethyldiethoxysilane, γ-methacryloxypropyltriethoxysilane, vinyltriacetoxysilane, γ-mercaptopropyltrimethoxysilane, γ-aminopropyltriethoxysilane, γ-anilinopropyltrimethoxysilane, γ-anilinopropylmethyldimethoxysilane, γ-[bis (β-hydroxyethyl)] aminopropyltriethoxysilane, N-β-(aminoethyl)-γ-aminopropyltrimethoxysilane, N-β-(aminoethyl)-γ-aminopropyltriethoxysilane, N-β-(aminoethyl)-γ-aminopropylmethyldimethoxysilane, phenylaminopropyltrimethoxysilane, γ-(β-aminoethyl)aminopropyldimethoxymethylsilane, N-(Trimethoxysilylpropyl)ethylenediamine, N-(dimethoxymethylsilylisopropyl)ethylenediamine, methyltrimethoxysilane, dimethyldimethoxysilane, methyltriethoxysilane, N-β-(N-vinylbenzylaminoethyl)-γ-Aminopropyltrimethoxysilane, γ-chloropropyltrimethoxysilane, hexamethyldisilane, vinyltrimethoxysilane, γ-mercaptopropylmethyldimethoxysilane, 3-isocyanuppropyltriethoxysilane, 3-acryloxypropyltrimethoxysilane, a hydrolysate of 3-triethoxysilyl-N-(1,3-dimethyl-butylidene)propylamine, and the like.

### · Titanate-Based Coupling Agent

Isopropyltriisostearoyl titanate, isopropyltris(dioctylpyrophosphate)titanate, isopropyltri(N-aminoethyl-aminoethyl) titanate,
tetraoctylbis(ditridecylphosphite)titanate, tetra(2,2-diallyloxymethyl-1-butyl)bis(ditridecyl)phosphite titanate, bis(dioctylpyrophosphate)oxyacetate titanate,
bis(dioctylpyrophosphate)ethylene titanate, isopropyltrioctanoyl titanate, isopropyldimethacrylic isostearoyl titanate, isopropyltridodecylbenzenesulfonyl titanate,
isopropylisostearoyl diacrylic titanate, isopropyltri(dioctyl phosphate)titanate, isopropyl tricumylphenyl titanate, tetraisopropylbis(dioctyl phosphate)titanate, and the like.

In a case where the encapsulating resin composition contains the coupling agent (E), the encapsulating resin composition may contain only one kind of coupling agent (E), or may contain two or more kinds of coupling agents (E).

A content of the coupling agent (E) is preferably equal to or more than 0.1% by mass, and more preferably equal to or more than 0.15% by mass with respect to the entirety of the encapsulating resin composition. Since the content of the coupling agent (E) is equal to or more than the above lower limit value, the dispersibility of the inorganic filling material can be improved.

On the other hand, the content of the coupling agent (E) is preferably equal to or less than 1% by mass, and more preferably equal to or less than 0.5% by mass with respect to the entirety of the encapsulating resin composition. Since the content of the coupling agent (E) is equal to or less than the above upper limit value, the fluidity of the encapsulating resin composition during the encapsulating molding can be improved, and the fillability or moldability can be improved.

### (Other Components)

The encapsulating resin composition of the present embodiment may further contain various additives such as an ion scavenger, a flame retardant, a colorant, a mold release agent, a low stress agent, an antioxidant, and a heavy metal inactivating agent, as necessary.

As the ion scavenger (also called an ion catcher, an ion trap agent, or the like), for example, hydrotalcite can be used. In addition, bismuth oxide and yttrium oxide are also known as ion scavengers.

In a case where the ion scavenger is used, only one kind may be used, or two or more kinds thereof may be used in combination.

In the case where the ion scavenger is used, a content thereof is, for example, 0.01 to 0.5% by mass, and preferably 0.05 to 0.3% by mass with respect to the entirety of the encapsulating resin composition.

Examples of the flame-retardant can include inorganic flame retardants (for example, hydrated metal-based compounds such as aluminum hydroxide, available from Sumitomo Chemical Co., Ltd.), halogen-based flame retardants, phosphorus-based flame retardants, organic metal salt-based flame retardants, and the like.

In a case where the flame retardant is used, only one kind may be used, or two or more kinds thereof may be used in combination.

The amount of the flame-retardant is, for example, 0 to 15% by mass, and preferably 0 to 10% by mass with respect to the entirety of the encapsulating resin composition.

Specific examples of the colorant include carbon black, colcothar, titanium oxide, and the like.

In a case where the colorant is used, only one kind may be used, or two or more kinds thereof may be used in combination.

In the case where the colorant is used, the amount thereof is, for example, 0.1 to 0.8% by mass, and preferably 0.2 to 0.5% by mass with respect to the entirety of the encapsulating resin composition.

Examples of the mold release agent include natural wax, synthetic wax such as montanic acid ester, higher fatty acid or metal salt thereof, paraffin, polyethylene oxide, and the like.

In a case where the mold release agent is used, only one kind may be used, or two or more kinds thereof may be used in combination.

In the case where the mold release agent is used, the amount thereof is, for example, 0.1 to 0.8% by mass, and preferably 0.2 to 0.5% by mass with respect to the entirety of the encapsulating resin composition.

Examples of the low stress agent can include silicone oil, silicone rubber, polyisoprene, polybutadiene such as 1,2-polybutadiene and 1,4-polybutadiene, styrene-butadiene rubber, acrylonitrile-butadiene rubber, polychloroprene, poly(oxypropylene), poly (oxytetramethylene)glycol, polyolefin glycol, thermoplastic elastomers such as poly-ε-caprolactone, polysulfide rubber, fluororubber, and the like.

Among these, silicone rubber, silicone oil, acrylonitrile-butadiene rubber, and the like are particularly preferable from the viewpoint of controlling a bending modulus of elasticity and a shrinkage rate within a desired range and suppressing warpage of the obtained power device.

In a case where the low stress agent is used, only one kind may be used, or two or more kinds thereof may be used in combination.

The amount of the low stress agent is, for example, 0 to 5% by mass, and preferably 0 to 3% by mass with respect to the entirety of the encapsulating resin composition.

Examples of the antioxidant include a phenol-based antioxidant (dibutylhydroxytoluene, or the like), a sulfur-based antioxidant (mercaptopropionic acid derivative, or the like), and a phosphorus-based antioxidant (9,10-dihydro-9-oxa-10-phosphaphenanthrene-10-oxide, or the like), and the like.

In a case where the antioxidant is used, only one kind may be used, or two or more kinds thereof may be used in combination.

In the case where the antioxidant is used, the amount thereof is, for example, 0 to 3% by mass, and preferably 0 to 2% by mass with respect to the entirety of the encapsulating resin composition.

Examples of the heavy metal inactivating agent can include ADEKA STAB CDA series (manufactured by ADEKA Corporation).

In a case where the heavy metal inactivating agent is used, only one kind may be used, or two or more kinds thereof may be used in combination.

The amount of the heavy metal inactivating agent is, for example, 0 to 1% by mass, and preferably 0 to 0.5% by mass with respect to the entirety of the encapsulating resin composition.

### (Method of Producing Encapsulating Resin Composition)

As described above, in the encapsulating resin composition of the present embodiment, in order to set the half width in the current-time curve in a case where the cured product is measured by the TSDC method to equal to or less than 800 seconds, a manufacturing method of producing an encapsulating resin composition (preparation method) is very important.

For example, an encapsulating resin composition can be obtained by mixing each of the above components by a known mixer or the like, melt-kneading the mixture by a kneader such as a roll, a kneader, or an extruder, and cooling and pulverizing the resulting mixture.

A shape of the encapsulating resin composition can be powder or granules as pulverized, a tablet shape formed by tableting after pulverizing, a shape obtained by sieving the pulverized one, or a granular shape produced by a granulaion method in which a degree of dispersion and a fluidity are appropriately adjusted by a centrifugal milling method, a hot-cut method, or the like.

As the finding of the present inventor, in particular, it is preferable to produce the encapsulating resin composition according to the following procedure.
· First, only the curing agent (C) and the curing accelerator (D) are mixed and melted (pre-melted) to obtain a melting mixture.
· Thereafter, the melting mixture is mixed with other components (the epoxy resin (A), the inorganic filler (B), and the like).

By employing such a manufacturing method, the half width of the current-time curve obtained in a case where the cured product of the encapsulating resin composition is measured by a thermally stimulated depolarization current method under specific conditions is easily set to equal to or less than 800 seconds.

The reason for this is not always clear, but it can be explained as follows.

It is considered that the curing accelerator (D) exhibits a function of promoting curing only in a case of being present "near" the curing agent (C).

The encapsulating resin composition is usually a solid or viscous liquid, and the flowing of components in a system during the heating and curing is limited. Therefore, it is considered that even though the encapsulating resin composition contains the curing agent (C) and the curing accelerator (D), the curing accelerator (D) does not sufficiently act on the curing agent (C) in a case where the distribution of the curing agent (C) and the curing accelerator (D) is not uniform in the composition, and as a result, the cross-linking reaction between the epoxy resin (A) and the curing agent (C) does not proceed more sufficiently. Thus, it is considered that the epoxy resin (A) and the curing agent (C), which are incompletely crosslinked, remain in the system to some extent.

Since the epoxy resin (A) and the curing agent (C) that are incompletely crosslinked are easily subjected to a structural alleviation by increasing the temperature after the voltage application is stopped, in addition to the incomplete cross-linking. In addition, it is considered that the peak of the current-time curve tends to be broad due to the structural alleviation.

On the other hand, the curing accelerator (D) is likely to be present "near" the curing agent (C) by pre-melting the curing agent (C) and the curing accelerator (D) to form a melting mixture. Thus, as described above, the epoxy resin (A) and the curing agent (C), which are incompletely crosslinked, are reduced. In addition, it is considered that a structural alleviation due to an increase in the temperature after the voltage application is stopped is reduced, and the half width of the peak of the current-time curve is narrowed.

The pre-melting step of the curing agent (C) and the curing accelerator (D) can be performed by, for example, the following steps.
(1) Only the curing agent (C) is melted. A melting temperature can be, for example, about 150°C to 160°C.
(2) The curing accelerator (D) is added to the melted curing agent (C) while maintaining the temperature. Thereafter, the mixture is stirred for about 10 to 15 minutes.
(3) The mixture is slowly cooled to room temperature and then pulverized.

Further, as the finding of the present inventor, in addition to the pre-melting of the curing agent (C) and the curing accelerator (D), the inorganic filler (B) subjected to the surface modification with a coupling agent such as a silane coupling agent is used to prepare the encapsulating resin composition. In this manner, the half width of the current-time curve obtained in a case where the cured product of the encapsulating resin composition is measured by a thermally stimulated depolarization current method under specific conditions is more easily set to equal to or less than 800 seconds.

The reason for this is also not always clear, but it can be explained as follows.

Since the surface of the inorganic filler (B) is modified with the coupling agent, the inorganic filler (B) in the encapsulating resin composition and a resin component are bonded and formed. The movability of the resin component bonded to the inorganic filler (B) is suppressed. Therefore, it is considered that the structural alleviation or the like due to an increase in the temperature after the voltage application is stopped is suppressed, and the half width of the peak of the current-time curve is narrowed.

(Here, the "resin component" means one or two or more of the epoxy resin (A), the curing agent (C), or a reaction product of the epoxy resin (A) and the curing agent (C).)

The surface modification method of the inorganic filler (B) with the coupling agent is as described above, for example. In particular, by sufficiently performing the above described aging treatment, the surface is appropriately modified, and a more sufficient HTRB resistance tends to be easily obtained.

Furthermore, as the finding of the present inventor, in a case where the curing agent (C) is a phenol-based curing agent, as described above, it is considered that the number of uncrosslinked sites is reduced by appropriately adjusting the amount (molar equivalent) of the epoxy resin (A) with respect to the phenol-based curing agent, so that the number of polar groups that are easy to move and to be subjected to a structural alleviation is reduced. Thereby, it is considered that a better HTRB resistance is easily obtained.

### (Power Device)

The power device of the present embodiment includes a substrate, a power element mounted on the substrate, and an encapsulating material for encapsulating a power element. The encapsulating material contains a cured product formed of the encapsulating resin composition described above.

FIG. 1 is a cross-sectional view showing an example of a power device 100.

The power device 100 includes a power element 20 mounted on a substrate 30, and an encapsulating material 50 for encapsulating the power element 20.

The power element 20 is a power semiconductor element formed any of, for example, SiC, GaN, Ga₂O₃, diamond, or the like.

The encapsulating material 50 is constituted of a cured product obtained by curing the encapsulating resin composition of the present embodiment.

In the power device 100, as described above, the power element 20 is a power semiconductor element formed of, for example, SiC, GaN, Ga₂O₃, or diamond. The power device 100 can be operated at a high temperature of equal to or higher than 200°C.

The power device 100 can exhibit an excellent HTRB resistance by including the encapsulating material 50 formed using the encapsulating resin composition of the present embodiment. Therefore, reliability can be improved even in long-term use in a high temperature environment such as equal to or higher than 200°C.

The power element 20 can be, for example, a power semiconductor element having an input power of equal to or higher than 1.7 W.

A case where the substrate 30 is a circuit board is shown in FIG. 1. In this case, as shown in FIG. 1, for example, a plurality of solder balls 60 may be formed on the other surface of the substrate 30 opposite to one surface on which the power element 20 is mounted. The power element 20 is mounted on the substrate 30 and is electrically connected to the substrate 30 through a wire 40. On the other hand, the power element 20 may be flip-chip mounted on the substrate 30. Here, the wire 40 is made of, for example, copper.

The power element 20 is encapsulated with the encapsulating material 50 to cover the other surface of the power element 20 opposite to one surface facing the substrate 30. That is, with the encapsulating resin composition of the present embodiment, the other surface of the power element 20 mounted on the substrate 30 opposite to the one surface facing the substrate 30 can be encapsulated to be covered. In FIG. 1, the encapsulating material 50 is formed to cover the other surface and the side surface of the power element 20.

The encapsulating material 50 can be formed by, for example, performing encapsulating molding with the encapsulating resin composition using a known method such as a transfer molding method or a compression molding method.

FIG. 2 is a cross-sectional view showing an example of a power device 100 of the present embodiment, and the example is different from that of FIG. 1.

The power device 100 of FIG. 2 uses a lead frame as the substrate 30. In this case, the power element 20 is mounted on a die pad 32 of the substrate 30, for example, and is electrically connected to an outer lead 34 through the wire 40.

Similar to the example of FIG. 1, the power element 20 is a power semiconductor element formed of, for example, SiC, GaN, Ga₂O₃, or diamond.

Similar to the example of FIG. 1, the encapsulating material 50 is formed by using the encapsulating resin composition of the present embodiment.

Although the embodiments of the present invention have been described above, these are examples of the present invention, and various configurations other than the above can be employed within the scope of the claims.

In addition, the present invention is not limited to the above described embodiment, and modifications, improvements, or the like within the range in which the object of the present invention can be achieved as disclosed in the claims are included in the present invention.

### [Examples]

Embodiments of the present invention will be described in detail based on Examples and Comparative Examples. The present invention is not limited to Examples.

### <Preparation of Materials>

First, materials to be used will be described.

### (Epoxy Resin)

E-1032H60: Trisphenylmethane-type epoxy resin (Mitsubishi Chemical Corporation), epoxy equivalent of 171
NC-3500: Biphenylene skeleton-containing phenolaralkyl-type epoxy resin (NIPPON KAYAKU Co., Ltd.), epoxy equivalent of 205
YDCN-800-65: o-cresol novolac epoxy resin (NIPPON STEEL Chemical & Material Co., Ltd.), epoxy equivalent of 200
CNE195LL: o-cresol novolac epoxy resin (Chang Chun Group), epoxy equivalent of 200
NC-3000: Biphenylene skeleton-containing phenolaralkyl-type epoxy resin (NIPPON KAYAKU Co., Ltd.), epoxy equivalent of 276

### (Inorganic Filler)

S-CO: Fused spherical silica (Micron, Inc.), average particle size of 20 um, specific surface area of 1.7 m²/g
FMT-05: Melted and crushed silica (FUMITECH Co., Ltd.), average particle size of 4.7 µm, specific surface area of 5.5 m²/g
SO-25R: Fused spherical silica (Admatechs.), average particle size of 0.5 um, specific surface area of 6.0 m²/g

### (Curing Agent)

MEH-7500: Trisphenylmethane skeleton- containing phenol resin (Meiwa Plastic Industries, Ltd.), hydroxyl equivalent of 97
MEHC-7403H: Biphenylene skeleton-containing phenolaralkyl-type phenol resin (Meiwa Plastic Industries, Ltd.), hydroxyl equivalent of 139
HE910-20: Trisphenylmethane-type phenol resin (AIR WATER INC.), hydroxyl equivalent of 101
PR-51470: Phenol novolac resin (Sumitomo Bakelite Co., Ltd.), hydroxyl equivalent of 104
PR-HF-3: Phenol novolac resin (Sumitomo Bakelite Co., Ltd.), hydroxyl equivalent of 105
MEH-7851SS: Biphenylene skeleton-containing phenolaralkyl-type phenol resin (Meiwa Plastic Industries, Ltd.), hydroxyl equivalent of 203

### (Curing Accelerator)

TPP-BQ: 4-hydroxy-2-(triphenylphosphonium)phenolate (K·I Chemical Industry Co., LTD.)
C03-MB: Tetraphenylphosphonium 4,4'-sulfonyl diphenolate (Sumitomo Bakelite Co., Ltd.)

### (Colorant)

Carbon #5: Carbon Black (Mitsubishi Chemical Corporation)

### (Coupling Agent)

GPS-M: γ-glycidoxypropyltrimethoxysilane (produced by JNC Corporation)
CF-4083: Phenylaminopropyltrimethoxysilane (Dow Toray Co., Ltd.)

### (Mold Release Agent)

C-WAX: Carnauba wax (TOA KASEI CO., LTD.)

### (Ion Scavenger)

DHT-4H: Hydrotalcite (Kyowa Chemical Industry Co., Ltd.)

### (Heavy Metal Inactivating Agent)

CDA-1M: Complex containing 2-hydroxy-N-1H-1,2,4-triazol-3-ylbenzamide as a main component (produced by ADEKA CORPORATION)

### (Low Stress Agent)

FZ-3730: Silicone oil (Dow Toray Co., Ltd.)
CF-2152: Silicone rubber (Dow Toray Co., Ltd.)

### <Examples 1 to 5: Production of Encapsulating Resin Composition>

### (Pre-Melting of Curing Agent and Curing Accelerator)

First, each curing agent shown in Table 1 below was melted at 150°C.

Each curing accelerator also shown in Table 1 was mixed in the same manner, and then the mixture was continually stirred for 10 minutes.

The mixture was slowly cooled to room temperature and then pulverized to obtain a melting mixture of each of the curing agents and the curing accelerators.

### (Surface Modification of Inorganic Filler)

Among the inorganic fillers shown in Table 1, S-CO was surface-modified as follows.

First, the coupling agent GPS-M was added dropwise while stirring S-CO with a ribbon mixer, and then the coupling agent CF-4083 was added dropwise. These mass ratios were set as shown in Table 1 (62.00: 0.20:0.20 in Example 1). The stirring was performed at room temperature.

After completing the dropwise addition, stirring was continued for 15 minutes.

Thereafter, the mixture was left to stand in an environment of 20±5°C and 40% to 50% RH for three days and aged to obtain a surface-treated inorganic filler (treated silica).

### (Production of Encapsulating Resin Composition)

First, the melting mixture of the curing agent and the curing accelerator obtained as described above, surface-modified and treated silica with the coupling agent, an epoxy resin, an inorganic filler other than the treated silica, a colorant, a mold release agent, an ion scavenger, a heavy metal inactivating agent, and a low stress agent were mixed at room temperature using a Henschel mixer to obtain a mixture.

Then, the mixture was roll-kneaded at 70°C to 100°C to obtain a kneaded product.

The obtained kneaded product was cooled and then pulverized to obtain an encapsulating resin composition.

An amount ratio (parts by mass) of each component is as shown in Table 1.

In Table 1, a molar equivalent (epoxy group/hydroxy group) of functional groups with respect to the phenol-based curing agent and the epoxy resin are also described as "Ep/OH ratio".

In Table 1, the amount of the melting mixture of the curing agent and the curing accelerator is described as the amount of the curing agent and the curing accelerator contained in the used melting mixture. In addition, as for the amount of the coupling agent, the amount of the coupling agent used for modifying the surface of the inorganic filler is described as the amount of the coupling agent described above (in a case of producing the encapsulating resin composition, the coupling agent is not newly used).

### <Comparative Examples 1 to 5: Production of Encapsulating Resin Composition>

Each component shown in Table 1 was mixed at the amount ratio without performing pretreatment such as melt mixing of the curing agent and the curing accelerator and the surface modification of silica particles to obtain a mixture. Mixing was carried out at room temperature using a Henschel mixer.

Then, the mixture was roll-kneaded at 70°C to 100°C to obtain a kneaded product.

The obtained kneaded product was cooled and then pulverized to obtain an encapsulating resin composition.

### (Preparation of Test Piece for Evaluation)

The encapsulating resin composition obtained in each Example and each Comparative Example is injected into a mold using a transfer molding machine under conditions of a mold temperature of 175°C, an injection pressure of 9.8 MPa, and a curing time of 2 minutes and molded, and then, formed into a circular shape having a diameter of 100 mm and a thickness of 2 mm. After molding, after-curing was performed using an oven at 175°C for 4 hours. Thereafter, cooling was carried out to room temperature, and a test piece for an evaluation was obtained.

### (TSDC Measurement)

The TSDC measurement was performed on the test piece for the evaluation obtained above according to the following procedure using an apparatus of TS-POLAR manufactured by Rigaku Corporation.
(1) A temperature of the test piece was increased to 150°C at a rate of 5°C/min without applying a voltage to the test piece.
(2) A constant voltage of 500 V was applied for 30 minutes while maintaining the temperature of the test piece at 150°C.
(3) The temperature of the test piece was lowered to 45°C at a rate of 5°C/min while applying the constant voltage of 500 V.
(4) The application of the voltage is stopped while maintaining the temperature of the test piece at 45°C and the test piece was left to stand for 5 minutes.
(5) The temperature of the test piece was increased at a rate of 3.5°C/min without applying a voltage to the test piece. A value of the current flowing during the increase in the temperature was measured to obtain a current-time curve.

### (HTRB test: Evaluation of HTRB Resistance)

First, an IGBT (insulated gate bipolar transistor) element having a rated voltage of 1200 V was die-bonded to a frame of a package specification of TO-247 by using solder, and then wire-bonded with Al wire. This was encapsulated with the encapsulating resin composition of each of Examples or Comparative Examples to prepare a package for HTRB evaluation. A molding condition of the encapsulating resin composition was 175°C for two minutes, and an after-curing condition was 175°C for four hours.

A constant temperature bath (model type: ST-120) manufactured by ESPEC Corp. was set at 150°C, and the above described package for HTRB evaluation was placed in the constant temperature bath. Then, by using a high-voltage power supply (model type: HAR-2P300) manufactured by Matsusada Precision Inc., a voltage of 1080 V was continuously applied to the package for HTRB evaluation for one week.

Thereafter, the temperature of the constant temperature bath was turned back to room temperature, the applied voltage was cut off, and the package for HTRB evaluation was taken out from the constant temperature bath. The withstand voltage of the taken-out package was measured using a curve tracer (model type: CS-3200) manufactured by IWASAKI ELECTRIC CO., LTD.. In a case where the withstand voltage is equal to or higher than 1200 V, it is determined that the HTRB test has passed, and in a case where the withstand voltage is less than 1200 V, it is determined that the HTRB test has failed.

In addition, in order to confirm the basic performance of the encapsulating resin composition, a spiral flow and a gel time were also measured as follows.

### (Spiral Flow)

By using a low-pressure transfer molding machine (KTS-15 manufactured by Kohtaki Precision Machine Co., Ltd.), the encapsulating resin composition was injected into a spiral flow measuring die according to ANSI/ASTM D 3123-72, and a flow length was measured. In this case, the mold temperature was 175°C, the injection pressure was 6.9 MPa, and the holding time was 120 seconds as conditions.

The spiral flow is a parameter of fluidity, and the larger the value, the better the fluidity. The unit is cm.

### (Gel Time)

The encapsulating resin composition was placed on a hot plate controlled at 175°C and kneaded with a spatula at a stroke of about 1 time/sec. The time from the dissolution of the encapsulating resin composition by heat to the curing was measured and used as a gel time. The smaller the gel time, the faster the curing.

The compositions of the encapsulating resin composition and the like are shown in Table 1, and the evaluation results are summarized in Table 2. The amount of each component in Table 1 is represented by parts by mass.

As described above, in Examples 1 to 5, the amount of the melting mixture of the curing agent and the curing accelerator is described as the amount of the curing agent and the curing accelerator contained in the used melting mixture. Furthermore, as described above, in Examples 1 to 5, the amount of the coupling agent used for modifying the surface of the inorganic filler is described as the amount of the coupling agent described above.

**[Table 1]**

| Number of Example and Comparative Example | | Example 1 | Example 2 | Example 3 | Example 4 | Example 5 | Comparative Example 1 | Comparative Example 2 | Comparative Example 3 | Comparative Example 4 | Comparative Example 5 |
|---|---|---|---|---|---|---|---|---|---|---|---|
| Epoxy resin | E-1032H60 | 10.78 | | | | | | | | 7.61 | |
| | NC-3500 | | 10.89 | | 10.18 | | | 11.18 | | | |
| | YDCN-800-65 | | | 9.73 | | | 10.81 | | | | |
| | GNE195LL | | | | | 11.00 | | | | | 11.18 |
| | NC-3000 | | | | | | | | 12.10 | | |
| Inorganic filler | S-CO | 62.00 | 72.00 | 72.00 | 67.00 | 62.00 | 72.00 | 62.00 | 67.00 | 62.00 | 62.00 |
| | FMT-05 | 10.00 | | | 5.00 | 10.00 | | 10.00 | 5.00 | 10.00 | 10.00 |
| | SO-25R | 10.00 | 10.00 | 10.00 | 10.00 | 10.00 | 10.00 | 10.00 | 10.00 | 10.00 | 10.00 |
| Curing agent | MEH-7500 | 5.17 | | | | 4.93 | | | 4.00 | | |
| | MEHC-7403H | | | 6.37 | 5.92 | | | | | | |
| | HE910-20 | | | | | | | | | | 4.75 |
| | PR-51470 | | 5.21 | | | | 5.29 | | | | |
| | PR-HF-3 | | | | | | | 4.92 | | | |
| | MEH-785155 | | | | | | | | | 8.49 | |
| Curing accelerator | TPP-BQ | | 0.20 | 0.20 | 0.20 | | 0.20 | 0.20 | 0.20 | 0.20 | |
| | C03-MB | 0.35 | | | | 0.37 | | | | | 0.37 |
| Colorant | Carbon #5 | 0.30 | 0.30 | 0.30 | 0.30 | 0.30 | 0.30 | 0.30 | 0.30 | 0.30 | 0.30 |
| Coupling agent | GPS-M | 0.20 | 0.20 | 0.20 | 0.20 | 0.20 | 0.20 | 0.20 | 0.20 | 0.20 | 0.20 |
| | GF-4083 | 0.20 | 0.20 | 0.20 | 0.20 | 0.20 | 0.20 | 0.20 | 0.20 | 0.20 | 0.20 |
| Mold release agent | C-WAX | 0.15 | 0.15 | 0.15 | 0.15 | 0.15 | 0.15 | 0.15 | 0.15 | 0.15 | 0.15 |
| Ion scavenger | DHT-4H | 0.10 | 0.10 | 0.10 | 0.10 | 0.10 | 0.10 | 0.10 | 0.10 | 0.10 | 0.10 |
| Heavy metal inactivating agent | CDA-1M | 0.05 | 0.05 | 0.05 | 0.05 | 0.05 | 0.05 | 0.05 | 0.05 | 0.05 | 0.05 |
| Low stress agent | FZ-3730 | 0.20 | 0.20 | 0.20 | 0.20 | 0.20 | 0.20 | 0.20 | 0.20 | 0.20 | 0.20 |
| | CF-2152 | 0.50 | 0.50 | 0.50 | 0.50 | 0.50 | 0.50 | 0.50 | 0.50 | 0.50 | 0.50 |
| Total | | 100.00 | 100.00 | 100.00 | 100.00 | 100.00 | 100.00 | 100.00 | 100.00 | 100.00 | 100.00 |
| Ep/OH ratio | | 1.15 | 1.05 | 1.05 | 1.15 | 1.05 | 1.05 | 1.15 | 1.05 | 1.05 | 1.15 |

**[Table 2]**

| Number of Example and Comparative Example | | Example 1 | Example 2 | Example 3 | Example 4 | Example 5 | Comparative Example 1 | Comparative Example 2 | Comparative Example 3 | Comparative Example 4 | Comparative Example 5 |
|---|---|---|---|---|---|---|---|---|---|---|---|
| Half width of current-time curve | Unit: sec | 702 | 738 | 730 | 711 | 744 | 820 | 857 | 833 | 838 | 862 |
| Peak height of current-time curve | Unit: pA | 1123 | 829 | 973 | 1197 | 831 | 735 | 549 | 662 | 673 | 588 |
| HTRB test | - | Pass | Pass | Pass | Pass | Pass | Fail | Fail | Fail | Fail | Fail |
| Spiral flow | Unit: cm | 120 | 97 | 118 | 109 | 121 | 94 | 127 | 133 | 146 | 143 |
| Gel time | Unit: sec | 36 | 40 | 37 | 40 | 39 | 44 | 38 | 40 | 43 | 40 |

From the above tables and the like, it was illustrated that the encapsulating resin composition having the half width of the current-time curve of equal to or less than 800 seconds, which is obtained according to the specific procedure was designed, and the power element was encapsulated with the composition to obtain the excellent HTRB resistance.

More specifically, it was illustrated that (1) the encapsulating resin composition including the epoxy resin, the inorganic filler, the curing agent, and the curing accelerator and having the half width of the current-time curve of equal to or less than 800 seconds could be produced by performing the pre-melting treatment of the curing agent and the curing accelerator and the surface treatment of the inorganic filler (treatment with the silane coupling agent and the aging treatment), and (2) the power element is encapsulated with the composition, so that the power device having the excellent HTRB resistance could be manufactured.

## Claims

1. An encapsulating resin composition for a power device comprising:
an epoxy resin (A);
an inorganic filler (B);
a curing agent (C); and
a curing accelerator (D),
wherein the inorganic filler (B) contains a surface-treated silica which is modified with a coupling agent, and
wherein the encapsulating resin composition is molded under a condition of 175°C for 2 minutes and then subjected to after-curing under a condition of 175°C for 4 hours to obtain a test piece having a diameter of 100 mm and a thickness of 2 mm, and a half width of a current-time curve obtained by measuring the test piece with a thermally stimulated depolarization current method according to an order of (i) to (v) below is equal to or less than 800 seconds,
(i) a temperature of the test piece is increased to 150°C at a rate of 5°C/min without applying a voltage,
(ii) a constant voltage of 500 V is applied for 30 minutes while maintaining the temperature of the test piece at 150°C,
(iii) the temperature of the test piece is lowered to 45°C at a rate of 5°C/min while applying the constant voltage of 500 V,
(iv) the application of the voltage is stopped while maintaining the temperature of the test piece at 45°C and the test piece is left to stand for 5 minutes, and
(v) the temperature of the test piece is increased at a rate of 3.5°C/min without applying any voltage to the test piece, and a value of a current flowing during the increase in the temperature is measured to obtain a current-time curve.

2. The encapsulating resin composition according to claim 1,
wherein the encapsulating resin composition has a peak height of equal to or higher than 800 pA in the current-time curve.

3. The encapsulating resin composition according to claim 1 or 2,
wherein the surface-treated silica is a silica which is treated with the coupling agent and aged.

4. The encapsulating resin composition according to any one of claims 1 to 3,
wherein the epoxy resin (A) is at least one selected from triphenylmethane-type epoxy resin and o-cresol novolac epoxy resin, and
the curing agent (C) is a triphenylmethane skeleton- containing phenol resin.

5. The encapsulating resin composition according to any one of claims 1 to 4,
wherein the curing agent (C) is a phenol-based curing agent, and
an amount of the epoxy resin (A) with respect to the phenol-based curing agent is 1.01 to 1.20 in terms of molar equivalent of functional groups.

6. The encapsulating resin composition according to any one of claims 1 to 5,
wherein an epoxy equivalent of the epoxy resin (A) is 100 to 400 g/eq.

7. A power device comprising:
a substrate;
a power element mounted on the substrate; and
an encapsulating material for encapsulating the electronic element,
wherein the encapsulating material contains a cured product formed of the encapsulating resin composition according to any one of claims 1 to 6.

## Patentansprüche

1. Einkapselungsharzzusammensetzung für ein Leistungsgerät, umfassend:
ein Epoxidharz (A);
einen anorganischen Füllstoff (B);
ein Härtungsmittel (C); und
einen Härtungsbeschleuniger (D),
wobei der anorganische Füllstoff (B) eine oberflächenbehandelte Kieselsäure enthält,
die mit einem Kupplungsmittel modifiziert ist, und
wobei die Einkapselungsharzzusammensetzung unter einer Bedingung von 175°C für 2 Minuten geformt und dann einer Nachhärtung unter einer Bedingung von 175°C für 4 Stunden unterzogen wird, um ein Teststück mit einem Durchmesser von 100 mm und einer Dicke von 2 mm zu erhalten, und eine Halbwertsbreite einer Strom-Zeit-Kurve, erhalten durch Messung des Teststücks mit einem thermisch stimulierten Depolarisationsstromverfahren gemäß einer Reihenfolge von (i) bis (v) nachstehend,
gleich oder kleiner als 800 Sekunden ist,
(i) eine Temperatur des Prüfstücks wird mit einer Geschwindigkeit von 5 °C/min auf 150 °C erhöht, ohne dass eine Spannung angelegt wird,
(ii) eine konstante Spannung von 500 V wird 30 Minuten lang angelegt, während die Temperatur des Teststücks bei 150°C gehalten wird,
(iii) die Temperatur des Prüfstücks wird mit einer Geschwindigkeit von 5°C/min auf 45°C gesenkt, während eine konstante Spannung von 500 V angelegt wird,
(iv) das Anlegen der Spannung wird gestoppt, während die Temperatur des Teststücks bei 45°C gehalten wird, und das Teststück wird 5 Minuten lang stehen gelassen, und
(v) die Temperatur des Teststücks wird mit einer Geschwindigkeit von 3,5°C/min erhöht, ohne dass irgendeine Spannung an das Teststück angelegt wird, und ein Wert eines Stroms, der während des Temperaturanstiegs fließt, wird gemessen, um eine Strom-Zeit-Kurve zu erhalten.

2. Einkapselungsharzzusammensetzung nach Anspruch 1, wobei die Einkapselungsharzzusammensetzung in der Strom-Zeit-Kurve eine Spitzenhöhe von mindestens 800 pA aufweist.

3. Einkapselungsharzzusammensetzung nach Anspruch 1 oder 2, wobei die oberflächenbehandelte Kieselsäure eine Kieselsäure ist, die mit dem Haftvermittler behandelt und gealtert wurde.

4. Einkapselungsharzzusammensetzung nach einem der Ansprüche 1 bis 3, wobei das Epoxidharz (A) mindestens eines ist, ausgewählt aus Epoxidharz vom Triphenylmethan-Typ und o-Kresol- Novolak- Epoxidharz, und
der Härter (C) ein Triphenylmethan-Gerüst enthaltendes Phenolharz ist.

5. Einkapselungsharzzusammensetzung nach einem der Ansprüche 1 bis 4,
wobei der Härter (C) ein Härter auf Phenolbasis ist, und
eine Menge des Epoxidharzes (A) in Bezug auf das Härtungsmittel auf Phenolbasis 1,01 bis 1,20, ausgedrückt als molares Äquivalent der funktionellen Gruppen, beträgt.

6. Einkapselungsharzzusammensetzung nach einem der Ansprüche 1 bis 5,
wobei ein Epoxidäquivalent des Epoxidharzes (A) 100 bis 400 g/Äq. beträgt.

7. Leistungsgerät, umfassend:
ein Substrat;
ein auf dem Substrat montiertes Leistungselement; und
ein Einkapselungsmaterial zum Einkapseln des elektronischen Elements,
wobei das Einkapselungsmaterial ein gehärtetes Produkt enthält, das aus der Einkapselungsharzzusammensetzung gemäß einem der Ansprüche 1 bis 6 gebildet ist.

## Revendications

1. Composition de résine d'encapsulation pour un dispositif d'alimentation comprenant :
une résine époxy (A) ;
une charge inorganique (B) ;
un agent durcissant (C) ; et
un accélérateur de durcissement (D),
dans laquelle la charge inorganique (B) contient une silice à surface traitée qui est modifiée avec un agent d'accrochage, et
dans laquelle la composition de résine d'encapsulation est moulée à une condition de 175 °C pendant 2 minutes, puis soumise à un post-durcissement à une condition de 175 °C pendant 4 heures pour obtenir une éprouvette ayant un diamètre de 100 mm et une épaisseur de 2 mm, et une demi-largeur d'une courbe de courant-temps obtenue en mesurant l'éprouvette avec un procédé de courant de dépolarisation stimulé thermiquement en fonction d'un ordre de (i) à (v) ci-dessous est inférieure ou égale à 800 secondes,
(i) une température de l'éprouvette est augmentée à 150 °C à une vitesse de 5 °C/min sans appliquer de tension,
(ii) une tension constante de 500 V est appliquée pendant 30 minutes tout en maintenant la température de l'éprouvette à 150 °C,
(iii) la température de l'éprouvette est abaissée à 45 °C à une vitesse de 5 °C/min tout en appliquant la tension constante de 500 V,
(iv) l'application de la tension est arrêtée tout en maintenant la température de l'éprouvette à 45 °C et l'éprouvette est laissée au repos pendant 5 minutes, et
(v) la température de l'éprouvette est augmentée à une vitesse de 3,5 °C/min sans appliquer de tension à l'éprouvette, et une valeur d'un courant s'écoulant au cours de l'augmentation de la température est mesurée pour obtenir une courbe de courant-temps.

2. Composition de résine d'encapsulation selon la revendication 1,
dans laquelle la composition de résine d'encapsulation a une hauteur de pic supérieure ou égale à 800 pA dans la courbe de courant-temps.

3. Composition de résine d'encapsulation selon la revendication 1 ou 2,
dans laquelle la silice à surface traitée est une silice qui est traitée avec l'agent d'accrochage et vieillie.

4. Composition de résine d'encapsulation selon l'une quelconque des revendications 1 à 3,
dans laquelle la résine époxy (A) est au moins une sélectionnée parmi une résine époxy de type triphénylméthane et une résine époxy novolaque o-crésol, et l'agent durcissant (C) est une résine de phénol contenant un squelette de triphénylméthane.

5. Composition de résine d'encapsulation selon l'une quelconque des revendications 1 à 4,
dans laquelle l'agent durcissant (C) est un agent durcissant à base de phénol, et une quantité de la résine époxy (A) par rapport à l'agent durcissant à base de phénol est de 1,01 à 1,20 en termes d'équivalent molaire de groupes fonctionnels.

6. Composition de résine d'encapsulation selon l'une quelconque des revendications 1 à 5,
dans laquelle un équivalent époxy de la résine époxy (A) est de 100 à 400 g/éq.

7. Dispositif d'alimentation comprenant :
un substrat ;
un élément d'alimentation monté sur le substrat ; et
un matériau d'encapsulation pour encapsuler l'élément électronique,
dans lequel le matériau d'encapsulation contient un produit durci formé de la composition de résine d'encapsulation selon l'une quelconque des revendications 1 à 6.
